# EUROPÄISCHE PATENTANMELDUNG

(11) **EP 1 355 424 A1**
(43) Veröffentlichungstag der Anmeldung: **22.10.2003**
(21) Anmeldenummer: 02360124.8
(22) Anmeldetag: 17.04.2002
(51) Int. Cl.: H03K 17/95

(54) **Sensoranordnung mit kabellos verbundenen Sensoreinheiten für eine Spannvorrichtung**

(71) Anmelder: SENSTRONIC, S.A., F-67700 Saverne (FR)
(72) Erfinder: Kirchdoerffer, Rémy, 67110 Reichshoffen (FR); Schmidt, Ralf, 67251 Freinsheim (DE)
(74) Vertreter: Nuss, Pierre

(57) **Zusammenfassung**

Die Erfindung betrifft eine Sensoranordnung, z.B. zur Ermittlung der Position eines Elements, welche mindestens eine Sensoreinheit und eine elektronische Versorgungs- und Empfangseinheit aufweist, wobei die beiden Einheiten in zwei voneinander unabhängigen Gehäusen untergebracht sind, dadurch gekennzeichnet dass die Energie zum Betreiben der mindestens einen Sensoreinheit (3, 3') zwischen den Gehäusen (5 und 6) durch magnetische Induktion übertragen wird, wobei des Gehäuse (6) der Versorgungs- und Empfangseinheit (4) eine hierzu elektrisch verbundene Primärspule (7) und das Gehäuse (5) der mindestens einen Sensoreinheit (3, 3') eine hierzu elektrisch verbundene Sekundärspule (8), cines somit gemeinsam gebildeten Transformators (7 und 8), beinhaltet, und dass die Sensorzustände mittels einer kabelloscn Übertragung an die Versorgungs- und Empfangseinheit (4) übermittelt werden.

## Beschreibung

Die vorliegende Erfindung bezieht sich auf das Gebiet der Abtastung und der Erfassung der Position und gegebenenfalls der Bewegung eines, zum Beispiel elektromagnetische Felder, beeinflussenden Gegenstandes, und betrifft eine Sensoranordnung mit kabelos verbundenen Einheiten, sowie eine Spannvorrichtung die eine solche Sensoranordnung aufweist.

Es sind schon verschiedene Sensortypen bekannt, die in der Lage sind die Position bzw. Bewegung eines Elements zur Erfassen.

Es sind insbesondere Sensoren bekannt die nach dem induktiven und kapazitiven Wirkprinzip arbeiten und gewöhnlich LC-Schwingkreise aufweisen, wobei die Spule "L" der aktiven Fläche zugewendet ist und in ihren Eigenschaften von einem äusseren beeinflussenden, insbesondere bedämpfenden, zum Beispiel metallischen Element beeinflussbar ist.

Der LC-Schwingkreis bildet ein oszillierendes System, dass in einer bestimmten Frequenz selbsttätig schwingt. Durch die Beeinflussung der Spule sind die freien Schwingbedingungen nicht mehr gegeben, so dass die Schwingung abschwächt bzw. abreisst, bis das bedämpfende Element entfernt oder beseitigt ist und der Oszillator wieder weiter- oder anschwingen kann.

Sensoren dieser Art sind insbesondere aus den EP-Anmeldungen Nr. 01440262.2, Nr. 01440311.7 und Nr. 01440399.2 bekannt.

Nun gibt es Anwendungssumstände und- gelegenheiten in welchen, z.B. aus Räumlichkeits-, Verlegungs- und/oder Gestaltungsgründen, die Sensoranordnung in mindestens zwei physich getrennten Teilsysteme untergeteilt werden muss, nämlich ein Grundgehäuse und mindestens ein Satellitengehäuse.

Das Grundgehäuse beinhaltet dann die Auswertungselektronik und verfügt über Verbindungsmittel (Stecker) zur Stromversorgung und Signalübertragung nach Außen.

Das oder die Satellitengehäuse beinhalten die Sensoreinheiten.

Diese Sensoreinheiten können entweder als einzelne Sensoren in verschiedenen Gehäusen untergebracht werden oder als Doppelsensor in einem Gehäuse, wobei die zwei LC-Systeme in einem festen Abstand angeordnet sind.

In beiden Fällen sind beide Gehäuse durch Kabeln verbunden.

Einstellbare Systeme mit kabelverbundenen Satelliten benötigen zudem einen mechanischen Träger, auf dem das Grundgehäuse und der oder die Satelliten montiert und justiert werden können.

Durch die Applikation ist es immer sehr schwehr, die beiden Kabel so zu verlegen, dass
a) sie nicht beschädigt werden und
b) mindestens einer der Satelliten verstellbar bleibt, um den Schaltpunkt einzustellen.
c) bei Beschädigung immer der Austausch des kompletten Systems (Sensorik + Auswertung) möglich sein muß.

Ausserdem ist die Montage aufwendig und dadurch auch die Justage des Schaltpunktes.

Die Aufgabe der Erfindung besteht darin, die oben angegebenen Nachteile des derzeitigen Stands der Technik, zu beseitigen.

Somit betrifft die Erfindung eine Sensoranordnung, z.B. zur Ermittlung der Position und/oder der Bewegung eines Elements oder Teils, welche mindestens eine Sensoreinheit und eine elektronische Versorgungsund Empfangseinheit aufweist, wobei die beiden Einheiten in voneinander unabhängigen Gehäusen untergebracht sind.

Diese Sensoranordnung ist dadurch gekennzeichnet dass die Energie zum Betreiben der mindestens einen Sensoreinheit zwischen den Gehäusen durch magnetische Induktion übertragen wird, wobei des Gehäuse der Versorgungs- und Empfangseinheit eine - mit der elektrischen Versorgung verbundene - Primärspule und das Gehäuse der mindestens einen Sensoreinheit eine - hierzu elektrisch verbundene-Sekundärspule, eines somit gemeinsam gebildeten Transformators, beinhaltet, und dass die Sensorzustände mittels einer kabellosen Übertragung an die Versorgungs- und Empfangseinheit übermittelt werden.

In der Tat, löst eine völlig kabellose Verbindung bzw. Übertragung zwischen den Einheiten alle vorgenannten Probleme, indem sie eine einfache Montage, eine große Betriebssicherheit und eine sehr einfache Justage erlauben, und dadurch auch geringste Montage- und Instandhaltungszeiten.

Es ist zu verstehen, dass die Erfindung sowohl in Sensoranordnungen mit einer Sensoreinheit, wie auch Sensoranordnungen mit mehreren Sensoreinheiten, Anwendung findet.

Vorzugsweise beinhaltet die erfinderische Sensoranordnung mindestens zwei - satellitenartige Sensoreinheiten, welche - beide - im selben Gehäuse untergebracht sind (oder in verschiedenen Gehäusen) und als nach einen induktiven Prinzip arbeitende Näherungsschalter ausgebildet sind, wobei das zu erfassende bewegliche Element oder Teil zumindest teilweise aus einem magnetische Felder beeinflussenden Material besteht.

Gemäss einer ersten Variante der Erfindung erfolgt die Übermittlung der Sensorzustände an die Versorgungs- und Empfangseinheit vorzugsweise durch induktive oder kapazitive Kopplung oder Rückkopplung.

Gemäss einer zweiten Variante der Erfindung erfolgt die Übermittlung der Sensorzustände an die Versorgungs- und Empfangseinheit über mittelbare oder unmittelbare elektrische Kontakte zwischen den beiden Gehäusen.

Beide Gehäuse können z.B. mit Kontaktlemmen ausgestattet sein.

Gemäss einer dritten Variante der Erfindung, erfolgt die Übermittlung der Sensorzustände an die Versorgungs- und Empfangseinheit in optischer Form, nachdem ein entsprechendes optisches Signal erstellt worden ist.

Einer bevorzugten Ausbildung der Erfindung folgend, ist jede Sensoreinheit als LC-Schwingkreis ausgebildet und der Zustand jedes Sensors wird basierend auf seinem Energieverbrauch ermittelt, da der Stromverbrauch der Sensoren im schwingenden Zustand größer ist als im nicht schwingenden Zustand (z.B. nachdem die Schwingung abgerissen ist).

Die Sensoreinheiten können jedoch auch gegebenenfalls so ausgebildet sein, dass sie eine analoge Erfassung durchführen.

Die Montage der Sensoreinheiten in ihrem gemeinsamen Gehäuse kann derartig ausgelegt sein, dass die oder wenigstens eine der Sensoreinheit(en) wenigstens entlang einer Translationsrichtung und/oder wenigstens um eine Rotationsachse verstellbar angeordnet ist, gegebenenfalls in Abhängigkeit der Bewegungsmöglichkeiten des zu erfassenden Teils oder Elements.

Um die Sensoreinheiten von äusseren Einflüssen (Stoß, Schlag, Aufprall, Aufdruck, Schmutz, ...) zu schützen und sie starr mit der Applikation zu verbinden, kann erfindungsgemäss vorgesehen werden, dass das Gehäuse der Sensoreinheit(en), zumindest teilweise, vorzugsweise ganz, fest in das Gehäuse oder die Struktur der Vorrichtung, welche das zu erfassende bewegliche Teil oder Element aufweist, intergiert ist, wobei das Gehäuse der Versorgungs- und Empfangseinheit auf der Außenseite dieses Gehäuses oder dieser Struktur, vorzugsweise leicht abnehmbar, angebracht ist.

Gemäss einer vorteilhaften praktischen Ausbildung der Erfindung, beinhaltet die Versorgungs- und Empfangseinheit folgende, die Grundelektronik bildenden Komponenten:
- eine elektronische Schaltung zum Treiben des Transformators,
- eine elektronische Schaltung zum Empfang der Sensorzustände,
- der Empfangselektronik nachgeschalteten Schalterstärkerund/oder Busansschlussschaltungen,
- Verbindungsmittel, insbesondere Steckverbindungsmittel, zum Anschluss der Versorgungs- und Empfangseinheit an eine Stromversorgung und an eine etwaïge verlegte signalweiterverarbeitende Elektronik.

Die Erfindung betrifft auch eine Spannvorrichtung welche insbesondere ein bewegliches Element oder Teil, wie z.B. eine Kolbenstange, beinhaltet, dessen Position vom Schliess- und Öffnungszustand der Spannvorrichtung abhängt, dadurch gekennzeichnet dass sie eine erfindungsgemässe Sensoranordnung aufweist, welche mindestens zwei Satelliten- oder Sensoreinheiten beinhaltet, die spatiiert entlang einer Achse die sich parallel zur Bewegungsrichtung des beweglichen Teils oder Elements erstreckt angeordnet sind.

Die Ermittlung der Position des bewegliche Teils oder Element kann gegebenenfalls auf analoge Weise erfolgen.

In der folgenden Beschreibung wird nun die Erfindung an Hand von Ausführungsbeispielen näher erläutert, dies im Zusammenhang mit den anliegenden schematischen Figuren.

Es zeigen:
Figur 1: eine perspektivistische Teilansicht eine Spanngreiferteils mit einer Sensoranordnung gemäss der Erfindung ;
Figur 2 : eine Draufsicht einer Sensoranordnung gemäss der Erfindung;
Figur 3 : eine Ansicht in Richtung A der Sensoranordnung der Figur 2 ;
Figur 4 : eine schematische Darstellung einer Sensoranordnung gemäss der Erfindung.

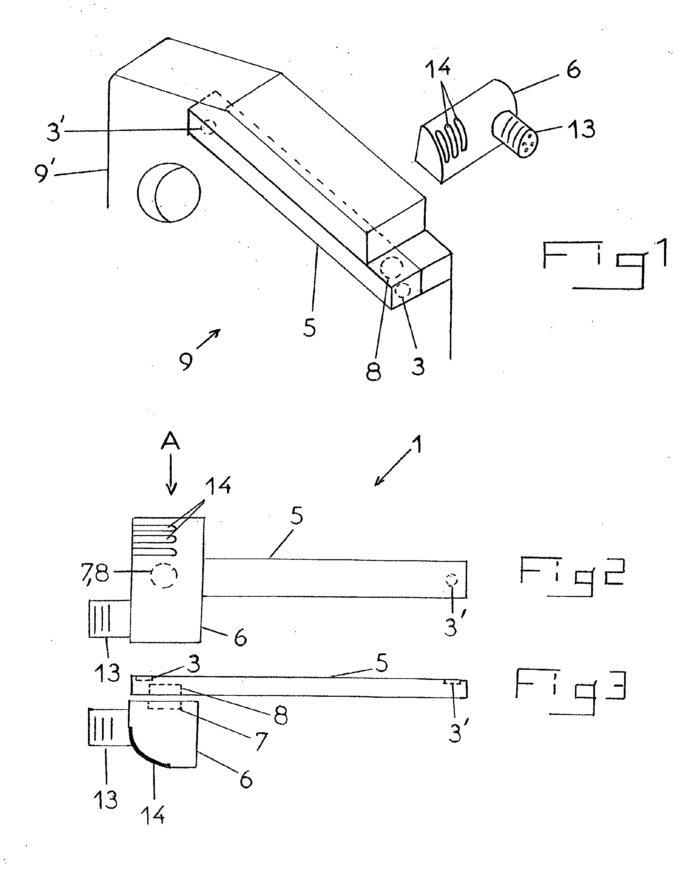

Die Sensoranordnung 1 der Figuren 1, 2, 3 und 4 weist zwei als Satelliten ausgebildeten Sensoreinheiten 3 und 3' und eine Versorgungsund Empfangseinheit 4, welche auch die primäre Auswertungselektronik beinhaltet, auf.

Die dargestellten satellitenartigen Sensoreinheiten 3 und 3' arbeiten vorzugsweise nach einem induktiven Erfassungsprinzip und sind in einem gemeinsamen Gehäuse 5 untergebracht.

Die elektronische Einheit 4 (hierunter auch Auswerteelektronik oder Grundelektronik genannt) ist in einem zweiten, getrennten Gehäuse 6 untergebracht.

Die Energie zum Betreiben der mindestens einen Sensoreinheit 3, 3' wird durch magnetische Induktion übertragen, wobei das Gehäuse 6 der Versorgungs- und Empfangseinheit 4 eine Primärspule 7 und das Gehäuse 5 der mindestens einen Sensoreinheit 3, 3' eine - letzere speisende - Sekundärspule 8, eines somit gemeinsam gebildeten Transformators 7 und 8, beinhaltet, und die Sensorzustände mittels einer kabellosen Übertragung an die Versorgungs- und Empfangseinheit 4 übermittelt werden.

Die beiden Sensoreinheiten 3 und 3' können entweder festgelegte oder, in ihren Positionen, einstellbare oder variable empfindliche Flächen (welche die flache Spule des LC-Schwingkreises tragen) aufweisen.

Dieses Sensorgehäuse 5 kann jedoch auch eine Sensorik beinhalten welche eine analoge Erfassung des beweglichen Teils oder Elements 2 vollbringt.

Da keine Kabelverbindung zwischen den oder dem Sensorgehäuse(n) 5 und dem Auswerteelektronikgehäuse 6 besteht, wird die Energie zum betreiben der Sensoreinheiten 3 und 3' durch einen Transformator übertragen, bei dem die Primärspule 7 in das Gehäuse 6 der Auswerteeletronik integriert ist, und die Sekundärspule 8 des Transformators oder in den im Sensorgehäuse(n) 5 enthalten ist.

Die Sensorzustände werden entweder induktiv, kapazitiv, optisch oder über elektrische Kontakte an die Empfangs- und Auswerteelektronik im Grundgehäuse 6 zurück übertragen.

Das Sensorgehäuse 5 kann fest in die Applikation - z.B. ein Kraftspanner - integriert werden, ohne auf die leichte Austauschbarkeit zu achten, weil Beschädigungen erfahrungsgemäss nur an der Kabelverbindung zur Auswerteeletronik oder an deren Gehäuse auftreten.

Durch die magnetische Induktion, gegeben durch:
- die elektrische Dimensionierung
- die mechanische Anordnung der primären Transformatorspule 7 im Grundgehäuse 6 und
- die mechanische Anordnung der sekundären Transformatorspule 8 im Sensor- oder Satellitengehäuse 5,
wird in die Sekundärspule 8 eine Leistung übertragen, die pro Satellit oder Sensoreinheit 3, 3' ca. 30 mW zur Versorgung eines herkömmlichen LC-Schwingkreises, wie er in induktiven Näherungsschaltern üblich ist, bereit stellt.

Jeder dieser LC-Schwingkreise ändert in Abhängigkeit der Anwesenheit bzw. Stellung eines vorhandenen Betätigungselements (BE) 2 seinen Energiebedarf. In den meisten Fällen wird der Schwingkreis jeder Sensoreinheit so abgeglichen, dass die Schwingung abreisst, wenn das Betätigungselement 2 einen gewünschten Abstand (Schaltabstand) unterschreitet.

Schwingend fliesst dann z.B. ein höherer Versorgungsstrom als nicht schwingend (<3mA; >1mA).

Diese beiden Zustände können induktiv rückgemeldet werden, indem z.B. jeder Satellit 3, 3' mit einer anderen Frequenz seinen Schwingungszustand an die Grundelektronik meldet, oder indem die Belastung, die jeder Satellit 3, 3' auf den Transformator 7, 8 darstellt, in der Empfangs- und Auswerteelektronik 4 detektiert wird.

Die Rückmeldung kann jedoch auch optisch erfolgen, wobei jeder Satellit eine LED treibt, die mit dem Schwingungszustand des entsprechenden LC-Schingkreises dann erlischt oder ihre Frequenz ändert.

Das Licht der LEDs kann z.B. durch eine Abdeckung als Lichtleiter vom infragestehenden Satelliten 3, 3' zu jeweils einem Empfänger in Grundgehäuse 6 übertragen werden, so dass in allen Fällen die Empfangs-und Auswerteelektronik eine geschlossene Einheit (4 in 6) bilden kann, wie auch die Satelliten (3, 3' in 5).

Die Spulen 7 und 8 können vorzugsweise als platzsparende platte einandergegenüberliegende Scheibensspulen ausgebildet sein (siehe Figuren 2 und 3).

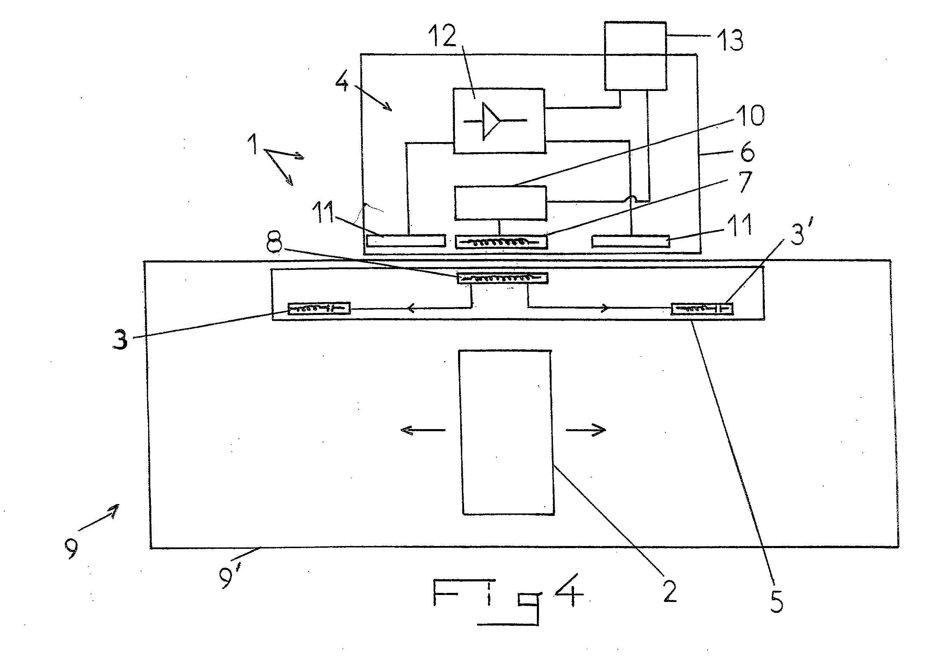

Wie dies teilweise aus der Figur 1 und der Figur 4 hervorgeht, betrifft die Erfindung auch eine Spannvorrichtung (z.B. Kniehebelspannvorrichtung oder Kurvenklemmgreifer) bei der die Position einer Kolbenstange erfasst werden kann, derart:
- dass die Sensoreinheiten 3, 3' zur Erfassung der Position in einem separaten Gehäuse 5 untergebracht werden und ohne Kabelverbindung mit Leistung versorgt werden,
- dass die Position der Kolbenstange (als Element 2) ebenso ohne Kabelverbindung an eine weiterverarbeitende Elektronik (Empfangs- und Auswerteelektronik) übertragen wird,
- dass das Sensorgehäuse 5 in das Gehäuse 9' der Spannvorrichtung 9 strukturell integriert wird, wobei von außen her keine insb. schlitzförmige Öffnungen notwendig sind;
- dass alle Flächen der Spannvorrichtung 9 zur deren Befestigung zur Verfügung stehen und
- dass die Spannvorrichtung 9 nicht demontiert werden muss um die Versorgungs- und Empfangseinheit 4 (inkl. Auswerteelektronik) zu tauschen.

In der im Gehäuse 6 integrierten primären Auswerteelektronik, oder gegebenenfalls in der nachgeschalteten und verlegten Auswerteelektronik, können verschiedene Funktionsparameter ermittelt werden, wie z.B. Schließ- und Öffnungsgeschwindigkeit des Spanners 9, Beschleunigung, Anzahl der Schliesszyklen und ähnliche Parameter, so dass beim Verlassen einer gegebenen Toleranzgrenze ein Fehlersignal generiert werden kann.

Im Gehäuse 6, welches die Grundelektronik (Versorgungs- und Empfangseinheit 4, und eventuelle primäre Auswerteeletronik) aufnimmt, befinden sich insbesondere:
- die Elektronik 10 zum Treiben des Tansformators 6, 7;
- die Empfangselektronik 11 zum Empfang und zur Aufnahme der Sensorzustände;
- die (beiden) Schaltverstärker 12 oder eine Busanschaltung und
- der Stecker 13 zum Anschluss an eine Spannungsversorgung und eine weiterverarbeitende Elektronik.
- lokale Anzeigemittel 14, welche z.B. den Schaltzustand und/oder den generellen Zustand der Sensoranordnung angeben.

Da durch äußere Einflüsse nur diese elektronische Einheit 4 beschädigt werden kann, muss nur diese, sehr leicht zu entnehmende und zu montierende Elektronik ausgewechselt werden.

Bei vergleichbaren bekannten Lösungen, siehe z.B. DE 196 16 441 C1, muss, um die Elektronik zu wechseln, die Spannvorrichtung abmontiert werden, insbesondere wenn sie von der Rückseite her besfestigt ist.

Durch die Abwesenheit jeglicher Verbindungskabeln in der erfindungsgemässen Sensoranordnung, sind somit:
- Montagezeiten,
- Instandhaltungszeiten und
- Beschädigungswahrscheinlichkeiten bis auf ein Minimum reduziert.

Das Gehäuse 5 welches die Sekundärspule 7 und die Sensoreinheiten 3 und 3' beinhaltet bildet somit eine geschlossene Sensorkassette die als Einheit vorab hergestellt und in die Applikation integriert werden kann, bei der Herstellung dieser Applikation.

Selbstverständlich ist die Erfindung nicht auf die beschriebenen und dargestellten Ausführungsformen begrenzt. Änderungen, z. B. in den Ausführungformen der verschiedenen Bestandteile oder Ersetzungen durch technische Äquivalente sind, soweit sie im Rahmen des beanspruchten Schutzbegehrens bleiben, jederzeit möglich.

## Patentansprüche

1. Sensoranordnung, z.B. zur Ermittlung der Position und/oder der Bewegung eines Elements oder Teils, welche mindestens eine Sensoreinheit und eine elektronische Versorgungs- und Empfangseinheit aufweist, wobei die beiden Einheiten in voneinander unabhängigen Gehäusen untergebracht sind, **dadurch gekennzeichnet dass** die Energie zum Betreiben der mindestens einen Sensoreinheit (3, 3') zwischen den Gehäusen (5 und 6) durch magnetische Induktion übertragen wird, wobei des Gehäuse (6) der Versorgungs- und Empfangseinheit (4) eine Primärspule (7) und das Gehäuse (5) der mindestens einen Sensoreinheit (3, 3') eine Sekundärspule (8), eines somit gemeinsam gebildeten Transformators (7 und 8), beinhaltet, und dass die Sensorzustände mittels einer kabellosen Übertragung an die Versorgungs- und Empfangseinheit (4) übermittelt werden.

2. Sensoranordnung gemäss Anspruch 1, **dadurch gekennzeichnet, dass** sie satellitenartige Sensoreinheiten (3 und 3') beinhaltet, welche im selben Gehäuse (5) untergebracht sind und als nach einen induktiven Prinzip arbeitende Näherungsschalter ausgebildet sind, wobei das zu erfassende bewegliche Element oder Teil (2) zumindest teilweise aus einem magnetische Felder beeinflussenden Material besteht.

3. Sensoranordnung gemäss Anspruch 1 oder 2, **dadurch gekennzeichnet, dass** die Übermittlung der Sensorzustände an die Versorgungs- und Empfangseinheit (4) kontaktlos erfolgt, vorzugsweise durch induktive oder kapazitive Kopplung oder Rückkopplung.

4. Sensoranordnung gemäss Anspruch 1 oder 2, **dadurch gekennzeichnet dass** die Übermittlung der Sensorzustände an die Versorgungs- und Empfangseinheit (4) über mittelbare oder unmittelbare elektrische Kontakte zwischen den beiden Gehäusen (5 und 6) erfolgt.

5. Sensoranordnung gemäss Anspruch 1 oder 2, **dadurch gekennzeichnet dass** die Übermittlung der Sensorzustände an die Versorgungs- und Empfangseinheit (4) in optischer Form erfolgt.

6. Sensoranordnung gemäss einem der Ansprüche 1 bis 5, dadurch gekennezeichnet dass jede Sensoreinheit (3, 3') als LC-Schwingkreis ausgebildet ist und dass der Zustand jedes Sensors (3, 3') basierend auf seinem Energieverbrauch ermittelt wird.

7. Sensoranordnung gemäss einem der Ansprüche 1 bis 6, dadurch gekennezeichnet dass die oder wenigstens eine der Sensoreinheit(en) (3, 3') wenigstens entlang einer Translationsrichtung und/oder wenigstens um eine Rotationsachse verstellbar angeordnet ist, gegebenenfalls in Abhängigkeit der Bewegungsmöglichkeiten des zu erfassenden Teils oder Elements (2).

8. Sensoranordnung gemäss einem der Ansprüche 1 bis 7, **dadurch gekennzeichnet dass** das Gehäuse (5) der Sensoreinheit(en) (3, 3'), zumindest teilweise, vorzugsweise ganz, fest in das Gehäuse oder die Struktur (9') der Vorrichtung (9), welche das zu erfassende bewegliche Teil oder Element (2) aufweist, intergiert ist, wobei das Gehäuse (6) der Versorgungs- und Empfangseinheit (4) auf der Außenseite dieses Gehäuses oder dieser Struktur (9'), vorzugsweise leicht abnehmbar, angebracht ist.

9. Sensoranordnung gemäss einem der Ansprüche 1 bis 8, **dadurch gekennzeichnet dass** die Versorgungs- und Empfangseinheit (4) folgende, die Grundelektronik bildenden Komponenten beinhaltet:
- eine elektronische Schaltung (10) zum Treiben des Transformators (7 und 8),
- eine elektronische Schaltung (11) zum Empfang der Sensorzustände,
- der Empfangselektronik nachgeschalteten Schalterstärkerund/oder Busansschlussschaltungen (12),
- Verbindungsmittel (13), insbesondere Steckverbindungsmittel, zum Anschluss der Versorgungsund Empfangseinheit (4) an eine Stromversorgung und an eine etwaïge verlegte signalweiterverarbeitende Elektronik.

10. Spannvorrichtung welche insbesondere ein bewegliches Element oder Teil, wie z.B. eine Kolbenstange, beinhaltet, dessen Position vom Schliess- und Öffnungszustand der Spannvorrichtung abhängt, **dadurch gekennzeichnet dass** sie eine Sensoranordnung (1) gemäss einem der Ansprüche 1 bis 9 aufweist, welche zwei Satelliten- oder Sensoreinheiten (3 und 3') beinhaltet, die spatiiert entlang einer Achse die sich parallel zur Bewegungsrichtung des beweglichen Teils oder Elements (2) erstreckt angeordnet sind.
